# EUROPEAN PATENT SPECIFICATION

(11) **EP 2 067 551 B1**
(45) Date of publication and mention of the grant of the patent: **10.04.2013**
(21) Application number: 07807431.7
(22) Date of filing: 11.09.2007
(51) Int. Cl.: B22F 1/00, B22F 9/24, C09C 1/62, C09C 3/08, C09D 5/24, C09D 7/12, H01B 1/02, H01B 1/22

(54) **SILVER PARTICLE COMPOSITE POWDER AND PROCESS FOR PRODUCTION THEREOF**
SILBERTEILCHENVERBUNDPULVER UND HERSTELLUNGSVERFAHREN DAFÜR
POUDRE COMPOSITE DE PARTICULES D'ARGENT ET SON PROCÉDÉ DE PRODUCTION

(30) Priority: 27.09.2006 JP 2006263362
(43) Date of publication of application: 10.06.2009
(73) Proprietor: DOWA Electronics Materials Co., Ltd., Chiyoda-ku Tokyo 101-0021 (JP)
(72) Inventor: OGI, Kozo, Chiyoda-ku Tokyo 101-0021 (JP); HISAEDA, Yutaka, Chiyoda-ku Tokyo 101-0021 (JP)
(74) Representative: Emde, Eric
(86) International application number: PCT/JP2007/068027
(87) International publication number: WO 2008/038535

(56) References cited:
- EP-A1- 1 579 935
- EP-A1- 1 666 408
- JP-A- 2005 298 921
- JP-A- 2006 169 613
- JP-A- 2006 219 693
- US-A1- 2006 199 008

## Description

### TECHNICAL FIELD

The present invention relates to a fine silver particle powder (especially having a nanometer-order particle size), more particularly, to such a silver particle powder and a silver particle powder dispersion favorably usable for a wiring forming material for forming a circuit micropattern, for example, for a wiring forming material for an inkjet method, for a film forming material substitutive for film formation by sputtering in a vacuum film formation process, and for a film forming material substitutive for film formation by plating in a wet process, or the like, and relates to a baked silver film obtained using the same.

### BACKGROUND ART

When the size of a solid substance is on an nm order (nanometer order), the specific surface area thereof is extremely large, and therefore, though it is solid, its interface with vapor or liquid is extremely large. Accordingly, its surface characteristics greatly control the properties of the solid substance. For a metal particle powder, it is known that the melting point of the powder dramatically lowers as compared with that as a bulk, and therefore, as compared with particles on a µm order, the powder has some advantages in that it enables micropatterning in wiring and it may be sintered at a low temperature. Of such a metal particle powder, a silver particle powder has low electric resistance and has high weather resistance, and the cost of the metal is lower than that of other noble metals, and therefore a silver particle powder is especially expected as a next-generation wiring material for micropatterning in wiring formation.

For forming electrodes and circuits for electric components and others, widely employed is a thick film paste method. A thick film paste is one prepared by dispersing a metal powder and, in addition to it, a glass frit, an inorganic oxide and the like in an organic vehicle. The paste is formed into a predetermined pattern by printing or dipping, and then heated at a temperature not lower than 500°C to remove the organic ingredient by firing thereby to sinter the particles together to give a conductor. The adhesiveness between the wiring formed according to the thick film paste method and the substrate may be secured by the glass frit having softened and fluidized in the baking step to wet the substrate, or by the softened and fluidized glass frit to penetrate into the sintered film of the wiring forming metal (glass bonding), or even by the inorganic oxide such as copper oxide or cadmium oxide to form a reactive oxide with the substrate (chemical bonding).

As compared with micron-size particles used in a conventional thick film paste, nano-size particles can be sintered at a low temperature and, for example, nanoparticles of silver can be sintered at 300°C or lower. When only the sintering of nanoparticles is taken into consideration, they may be baked at a temperature higher than 300°C; however, baking at a high temperature is disadvantageous in that the type of usable substrates is limited owing to the limitation on the heat resistance of substrates that are to be processed for electrode or circuit formation thereon, and in addition, it could not take advantage of the characteristic, low temperature sinterability of nanoparticles. For broadening the latitude in selecting the type of the objective substrates, the baking temperature is not higher than 300°C, preferably not higher than 250°C, more preferably not higher than 200°C, even more preferably not higher than 100°C, and is advantageously lower.

In case where the baking temperature is not higher than 300°C and is low, the glass frit, even though added according to a conventional thick film paste method, could not soften and fluidize and therefore could not wet the substrate, and as a result, there may occur a problem in that the adhesiveness to the substrate is poor. In particular, the adhesiveness to various substrates such as typically glass substrate and polyimide film substrate is poor, and therefore, it is desired to enhance the adhesiveness to glass substrate, polyimide film substrate and others.

Regarding the adhesiveness to substrate, proposed are a method comprising applying a paste that contains a metal particle dispersion of metal particles dispersed in an organic solvent and a silane coupling agent, onto a glass substrate, followed by baking it at a temperature of from 250 to 300°C (Patent Reference 1); a method comprising using particles having a mean particle diameter of from 0.5 to 20 µm and particles having a mean particle diameter of from 1 to 100 nm as combined, and dispersing them in a thermosetting resin to secure the adhesiveness owing to the thermosetting resin (Patent Reference 2); a method comprising using a metal colloid that has a lowermost exothermic peak at 300°C or lower (Patent Reference 3); etc.

| | |
|---|---|
| Patent Reference 1: | JP-A 2004-179125 |
| Patent Reference 2: | WO02/035554 |
| Patent Reference 3: | JP-A 2003-176455 |

### PROBLEMS THAT THE INVENTION IS TO SOLVE

In Patent Reference 1, a paste that contains a metal particle dispersion of metal particles dispersed in an organic solvent and a silane coupling agent is applied onto a glass substrate and then baked at a temperature of from 250 to 300°C to form thereon a thin metal film having excellent adhesiveness to the glass substrate and having a high density and a low electric resistance. According to the method, an organic vehicle with a high-molecular-weight ethyl cellulose or the like dissolved therein is not added to the ink. Accordingly, the baking does not specifically require a high temperature of not lower than 500°C, and the baking may be attained at 300°C or lower. However, since a silane coupling agent is added to the ink, it is problematic in that the ink viscosity changes with time and is further problematic in that the electric connection between the substrate and the wiring (thin metal film) is difficult to attain.

In Patent Reference 2, particles having a mean particle size of from 0.5 to 20 µm and particles having a mean particle size of from 1 to 100 nm, as combined, are dispersed in a thermosetting resin, to thereby make the thermosetting resin secure the adhesiveness to substrate. Since the adhesiveness is secured by the thermosetting resin, the dispersion may be baked at 300°C or lower; however, in case where an organic substance remains, and when a dielectric layer is formed on the formed wiring or when the wiring is kept in a vacuum atmosphere, then the dielectric layer may be swollen or the vacuum atmosphere may be polluted by the peeled organic substance, thereby causing a problem of circuit reliability reduction. In addition, as containing a resin, the paste has another problem in that its viscosity is difficult to lower.

In Patent Reference 3, a metal colloid having a lowermost exothermic peak at 300°C or lower is used to give a high-conductive and tough film by heating at a low temperature. However, the specific resistivity of the film baked at 200°C is at least 10 µΩ·cm, and this is problematic in that the resistivity of the film is high in application to wiring.

Further, reference is made to US 2006/199008 A1 which relates to fine silver particle powder suitable for interconnects used to form fine circuit patterns especially by the inkjet method, and a method of manufacturing the powder. The powder particles have a calculated specific surface area (CS) of 50 m²/cm³ or more, an X-ray crystal grain diameter (DX) of not more than 50 nm, not more than 10.0 basicity points/nm² and not more than 10.0 acidity points/nm². To obtain the silver particle powder, a silver compound is reduced in an organic solvent, using as the reducing agent one or more selected from an alcohol or polyol. The reduction reaction proceeds in the presence of an organic protective agent and a polarity inhibition agent.

The invention is to solve these problems, and its object is to improve the adhesiveness to glass substrates, polyimide film substrates and others in low-temperature baking at 300°C or lower in forming electrodes and circuits with a silver particle powder dispersion, and to produce a baked film which has a low electric resistance and is applicable to wiring. Specifically, the invention is to satisfy both enhanced adhesiveness and lowered electric resistance. The silver particle powder dispersion as referred to herein includes a high-viscosity silver particle powder dispersion of so-called paste.

### MEANS FOR SOLVING THE PROBLEMS

To attain the above-mentioned object, the invention provides a silver particle composite powder as set forth in claim 1, a dispersion of a silver particle powder as set forth in claim 3, a method for mixing a silver particle powder as set forth in claim 4 and a method for producing a baked silver film as set forth in claim 6.

In particular, the silver particle powder is produced by mixing a silver particle powder (A) which bears on the surface of each silver particle, an organic protective layer comprising an amine compound having at least one unsaturated bond in one molecule and having a molecular weight of from 100 to 1000, and has a mean particle diameter D_{TEM}, as determined by TEM (transmission electronic microscopy), of at most 50 nm and a silver particle powder (B) which bears on the surface of each silver particle, an organic protective layer comprising a fatty acid having a molecular weight of from 100 to 1000 and an amine compound having a molecular weight of from 100 to 1000 with at least any one of the fatty acid and the amine compound having at least one unsaturated bond in one molecule, and has a mean particle diameter D_{TEM} of at most 50 nm. The blend ratio of the silver particle powder (A) and the silver particle powder (B) is within a range of A/B by mass of from 3/1 to 1/3 in terms of silver. The silver particle composite powder has an exothermic peak, as determined by differential calorimetry, falling within a range of from 200 to lower than 400°C and within a range of from 400 to 600°C.

The mean particle diameter D_{TEM}, as determined by TEM, is computed as follows: On a 600,000-power enlarged TEM image, 300 independent particles not overlapping with each other are analyzed to determine their diameter, and the data are averaged. For the particle diameter of each particle, employed is the largest diameter (major diameter) measured on the image.

The invention also provides a dispersion of the silver particle composite powder produced by dispersing said silver particle composite powder in a non-polar or poorly-polar liquid organic medium having a boiling point of from 60 to 300°C. The dispersion is applied onto a substrate to form a coating film thereon, and thereafter the coating film is baked to realize a low-resistance baked silver film having good adhesiveness to the substrate and suitable to wiring application. The baking may be attained in an oxidizing atmosphere at a temperature not higher than 300°C and falling within a range within which silver is sintered.

For producing the silver particle composite powder, herein provided is a production method comprising mixing the above-mentioned silver particle powder (A) and silver particle powder (B) in a blend ratio by mass, A/B of from 3/1 to 1/3 in terms of silver. The silver particle powder (A) has an exothermic peak in differential calorimetry to fall within a range of from 400 to 600°C; and the silver particle powder (B) has an exothermic peak in differential calorimetry to fall within a range of from 200 to lower than 400°C and within a range of from 400 to 600°C.

Baked at a low temperature not higher than 300°C, the silver particle powder of the invention realizes a low-resistance baked film having good adhesiveness to a glass substrate, a polyimide film substrate or the like, and suitable to wiring application. In addition, as not containing a silane coupling agent, the invention may provide an ink free from a problem of time-dependent change; and as not containing a thermosetting resin, the invention may provide an ink having a low viscosity.

### PREFERRED EMBODIMENTS OF THE INVENTION

Heretofore the present inventors have repeatedly made experiments for producing a silver particle powder in a liquid-phase process, and have developed a method for producing a silver particle powder which comprises reducing silver nitrate in an alcohol having a boiling point of from 85 to 150°C, at a temperature of from 85 to 150°C in the presence of an organic protective agent comprising, for example, an amine compound having a molecular weight of from 100 to 400. The inventors have also developed a method for producing a silver particle powder, which comprises reducing a silver compound (typically silver carbonate or silver oxide) in an alcohol or a polyol having a boiling point of not lower than 85°C, at a temperature not lower than 85°C in the presence of an organic protective agent comprising, for example, a fatty acid having a molecular weight of from 100 to 400. According to these methods, a powder of silver nanoparticles having extremely good dispersibility can be obtained.

However, when the silver particle powder dispersion obtained according to these methods is applied onto a substrate to form a coating film thereon and thereafter the coating film is baked to give a baked silver film, then it has been found that the adhesiveness of the film to the substrate is not always sufficient. As a result of various investigations made thereafter, it has been confirmed that, in producing silver particles through the above-mentioned reduction treatment, when "a fatty acid" and "an amine compound", as combined, are added as the organic protective agent, then the particle size distribution of the produced silver particles may be broadened, and that the baked silver film formed by the use of the silver particle powder as a filler can have noticeably enhanced adhesiveness to the substrate. However, it cannot be said that the electric resistance of the baked silver film obtained in this case is considerably low, and further technical development is desired for reducing the electric resistance of the film for wiring application.

The inventors have further studied and, as a result, have found that when the silver particle powder having an organic protective layer of "fatty acid" and "amine compound" formed on each particle and having a broad particle size distribution is combined with a silver particle powder having an organic protective layer of "amine compound" formed in the absence of "fatty acid", then the excellent adhesiveness can be maintained and the resistance can be greatly lowered.

The matters specific to the invention are described below.

### [Mean Particle Diameter D_{TEM}]

The silver particle composite powder of the invention is produced by mixing a silver particle powder (A) of which the organic protective layer comprises "amine compound" (hereinafter this may be simply referred to as "powder (A)") and a silver particle powder (B) of which the organic protective layer comprises "fatty acid" and "amine compound" (hereinafter this may be simply referred to as "powder (B)"), in which both the powders (A) and (B) are fine ones having a mean particle diameter D_{TFM}, as determined through TEM, of at most 50 nm. Accordingly, D_{TEM} of the silver particle composite powder is also at most 50 nm. More preferably, it is at most 30 nm; and especially for use for inkjet, it is even more preferably at most 20 nm. Not specifically defined, the lowermost limit of the mean particle diameter D_{TEM} may be, for example, at least 3 nm. In producing the silver particle powders (A) and (B) respectively, the mean particle diameter D_{TEM} thereof may be controlled by controlling the molar ratio of alcohol or polyol/Ag, the molar ratio of organic protective agent/Ag, the molar ratio of reduction promoter/Ag, the heating speed in reduction, the stirring power, the type of the silver compound, the type of the alcohol or polyol, the type of the reduction promoter, the type of the organic protective agent, etc.

### [Alcohol or Polyol]

The silver particle powders (A) and (B) for use in the invention are both obtained by reducing a silver compound in a liquid of one or more alcohols or polyols. The alcohol or polyol functions as a medium and a reducing agent. The alcohol includes propyl alcohol, n-butanol, isobutanol, sec-butyl alcohol, hexyl alcohol, heptyl alcohol, octyl alcohol, allyl alcohol, crotyl alcohol, cyclopentanol, etc. The polyol includes diethylene glycol, triethylene glycol, tetraethylene glycol, etc. Above all, preferred are isobutanol and n-butanol.

### [Organic Protective Layer and Organic Protective Agent]

The silver particles to constitute the silver particle composite powder of the invention are coated with an organic protective layer on their surfaces. The organic protective layer is formed by making an organic protective agent present in the reduction in alcohol or polyol. However, the constitution of the organic protective layer differs between the silver particle powders (A) and (B) to be used for the source of the composite powder. For the silver particle powder (A), "amine compound" having at least one unsaturated bond is used as the organic protective agent. On the other hand, for the silver particle powder (B), "fatty acid" and "amine compound" are sued as the organic protective agent, and at least one of bott is composed of a compound having at least one unsaturated bond.

The fatty acid for the powder (B) and the amine compound for the powders (A) and (B) are substances having a molecular weight of from 100 to 1000. Those having a molecular weight of less than 100 could not sufficiently attain the effect of inhibiting particle aggregation. On the other hand, when the molecular weight thereof is too large, the substances could have a high aggregation inhibiting power, but the intergranular sintering in applying and baking the silver particle composite powder dispersion may be inhibited whereby the electric resistance of the wiring may increase and, as the case may be, the wiring could not have electric conductivity. Accordingly, both the fatty acid and the amine compound must have a molecular weight of at most 1000. More preferred are those having a molecular weight of from 100 to 400.

Typical fatty acids for use for the powder (B) include, for example, oleic acid, linolic acid, linolenic acid, palmitoleic acid, myristoleic acid. These may be used either singly or as combined. The amine compound for use for the powders (A) and (B) is preferably a primary amine. Typical amine compounds include, for example, hexanolamine, hexylamine, 2-ethylhexylamine, dodecylamine, octylamine, laurylamine, tetradecylamine, hexadecylamine, oleylamine, octadecylamine. Also these may be used either singly or as combined. A same type of the amine compound may be used for both the powders (A) and (B), or different types thereof may be for them.

### [Silver Compound]

For the source of silver for the powders (A) and (B), usable are silver compounds such as various silver salts and silver oxides. For example, they include silver chloride, silver nitrate, silver oxide, silver carbonate, etc.; and silver nitrate is preferred for industrial use.

### [Reduction Promoter]

In promoting the reduction in producing both the powders (A) and (B), a reduction promoter may be used. For the reduction promoter, usable is an amine compound having a molecular weight of from 100 to 1000. Of such amine compounds, preferred are secondary or tertiary amine compounds having a strong reducing power. Like the organic protective agent, the reduction promoter having a molecular weight of less than 100 may be poorly effective for inhibiting particle aggregation, while that having a molecular weight of more than 1000 may be effective for aggregation inhibition but may interfere with the intergranular sintering in applying and baking the silver particle powder dispersion, whereby the electric resistance of the wiring may increase and, as the case may be, the wiring could not have electric conductivity; and therefore, these are unsuitable. Typical amine compounds usable in the invention include, for example, diisopropylamine, diethanolamine, diphenylamine, dioctylamine, triethylamine, triethanolamine, N,N-dibutylethanolamine. In particular, diethanolamine and triethanolamine are preferred.

### [Liquid Organic Medium]

For producing a dispersion of the silver particle powder (A) or (B), as prepared through reduction, a non-polar or poorly-polar liquid organic medium having a boiling point of from 60 to 300°C is used in the invention. "Non-polar or poorly-polar" as referred to herein means that the relative dielectric constant at 25°C of the medium is at most 15, more preferably at most 5. In case where the relative dielectric constant of the medium is more than 15, the dispersibility of silver particles may worsen and they may settle, which is unfavorable. Depending on the use of the dispersion, various liquid organic media may be used, and hydrocarbons are preferred. In particular, herein usable are aliphatic hydrocarbons such as isooctane, n-decane, isododecane, isohexane, n-undecane, n-tetradecane, n-dodecane, tridecane, hexane, heptane; aromatic hydrocarbons such as benzene, toluene, xylene, ethylbenzene, decalin, tetralin; etc. One or more of these liquid organic media may be used. A mixture such as kerosene is also usable. Further, a polar organic medium of alcohols, ketones, ethers, esters and the like may be added to the liquid organic medium for controlling the polarity of the resulting mixture, within a range within which the specific dielectric constant at 25°C of the mixture could be at most 15.

Next described is a method for producing the silver particle powders in the invention.

### [Production of Silver Particle Powders (A), (B)]

The silver particle powders (A) and (B) for use in the invention may be produced both by reducing a silver compound in an alcohol or polyol in the presence of an organic protective agent. In producing the powder (A), "amine compound" is used as the organic protective agent, and "fatty acid" is not used. In producing the powder (B), "fatty acid" and "amine compound" are used as the organic protective agent, and the blend ratio of the two may be, for example, within a range of [fatty acid]/[amine compound] by mol of from 0.02/1 to 1/1, more preferably from 0.1/1 to 1/1. In producing both the powders (A) and (B), the Ag ion concentration in the liquid may be at least 50 mmol/L, for example, from 50 to 500 mmol/L or so.

In producing both the powders (A) and (B), the reduction may be attained under heat at 80 to 200°C, preferably at 85 to 150°C. Preferably, the reduction is attained under a reflux condition under which vaporization and condensation of alcohol or polyol serving both as a medium and as a reducing agent, are repeated. For efficiently conducting the reduction, the above-mentioned reduction promoter may be used. As a result of various investigations, the reduction promoter is preferably added nearly at the end of the reduction, and the amount of the reduction promoter to be added is preferably within a range of from 0.1 to 20 in terms of the ratio by mol to silver.

After the reaction, the silver nanoparticle suspension (slurry just after the reaction) is, for example, processed in steps of washing, dispersing, classifying and the like according to the process shown in Examples to be given hereinunder, thereby producing a dispersion of the silver particle powder (A) or (B) for use in the invention.

### [Mixing]

Produced silver particle powders (A) and (B) (the production method is not specifically defined, but for example, they may be produced as in the above) are prepared, and are mixed to give the silver particle composite powder of the invention. In case where the powders (A) and (B) produced according to the above-mentioned method are used, the liquid organic media in which they are dispersed are mixed and stirred to give a dispersion of the silver particle composite powder of the invention. The blend ratio of the silver particle powder (A) and the silver particle powder (B) is within a range of from 3/1 to 1/3 as a ratio A/B by mass in terms of silver. The ratio A/B may fall within a range of from 2.5/1 to 1/2, or from 2.5/1 to 1/1.5.

When the proportion of the powder (A) is too small, a baked silver film having a low electric resistance could hardly be formed; and when the proportion of the powder (B) is too small, a baked silver film having good adhesiveness could hardly be formed. From such experimental results, it may be considered that the powder (A) may have an effect of reducing the electric resistance of the baked silver film. Though the mechanism is not clarified, the reproducible resistance-reducing effect has been confirmed. On the other hand, it may be considered that the powder (B) may have an effect of enhancing the adhesiveness of the baked silver film to the substrate.

### [Exothermic Peak in Differential Colorimetry]

Both the silver particle powders (A) and (B) give an exothermic peak corresponding to the substance of the organic protective layer, in differential colorimetry. The silver particle powder (A) gives an exothermic peak within a range of from 400 to 600°C, corresponding to the amine compound. The silver particle powder (B) gives an exothermic peak within a range of from 400 to 600°C, corresponding to the amine compound, and further gives an exothermic peak within a range of from 200 to lower than 400°C, corresponding to the fatty acid.

### [Use of Silver Particle Composite Powder of the Invention]

The silver particle composite powder of the invention is favorable for a wiring forming material for forming circuit micropatterns, for example, a wiring forming material according to an inkjet method, for a film forming material substitutive for film formation by sputtering in a vacuum film formation process, for a film forming material substitutive for film formation by plating in a wet process, etc. The silver particle composite powder of the invention is also favorable for a wiring forming material for wiring on LSI substrates, for electrodes and wirings for FPDs (flat panel displays), and further for burying micro-size trenches, via holes, contact holes, etc. As capable of being baked at a low temperature, the powder is also applicable to an electrode forming material on a flexible film, and in electronics packaging, the powder may be used as a bonding material. The powder is also applicable to an electromagnetic wave shield film as a conductive film, to an IR reflection shield taking advantage of the optical characteristics of the powder in the field of transparent conductive films, etc. As having low-temperature sinterability and electroconductivity, the powder may be printed on a glass substrate and baked thereon to give antifogging heating wires for windshields for automobiles, etc. On the other hand, the dispersion is applicable not only to an inkjet method but also to other various coating methods of spin coating, dipping, blade coating or the like, and further to screen printing, etc.

### [Baking]

The dispersion of the silver particle composite powder of the invention is applied onto a substrate, and then baked to give a baked silver film. The baking is attained in an oxidizing atmosphere. The oxidizing atmosphere as referred to herein is a non-reducing atmosphere, therefore including a normal-pressure atmospheric environment, a reduced-pressure atmosphere, and an inert gas atmosphere with minor oxygen introduced thereinto. The baking temperature may be from 100 to 300°C, and may be a low temperature. However, depending on the mean particle diameter D_{TEM} and the condition of the coating film, the lowermost limit of the temperature at which silver may be sintered varies in some degree. In case where the coating film is not sintered at 100°C, it may be baked at a temperature falling within a range of from the lowermost temperature at which it is sintered to 300°C.

Not specifically defined, the baking apparatus may be any one capable of realizing the above-mentioned atmosphere and temperature. For example, it includes a hot air circulating drier, a belt-type baking furnace, an IR baking furnace, etc. In case where wirings or electrodes are formed on a film substrate (e.g., polyimide film substrate), not a batch-type apparatus but a continuous baking apparatus applicable to a roll-to-roll system for mass-production is preferred in view of the producibility thereof. Regarding the baking time, preferably, the substrate having the coating film formed thereon is kept within the above-mentioned temperature range for at least 10 minutes, more preferably for at least 60 minutes.

### EXAMPLES

### [Example 1]

### [Production of Silver Particle Powder (A)]

176 g of oleylamine, a primary amine compound, serving as an organic protective agent, and 22 g of silver nitrate crystal, a silver compound, were added to 64 g of isobutanol, a medium also serving as a reducing agent, and stirred with a magnetic stirrer to dissolve the silver nitrate. The solution was transferred into a container equipped with a refluxing condenser, and set in an oil bath. With introducing nitrogen gas, an inert gas, at a flow rate of 400 mL/min into the container and with stirring the liquid with a magnetic stirrer at a rotational speed of 100 rpm, this was heated and kept heated under reflux at a temperature of 108°C for 5 hours. In this stage, the heating speed up to 108°C was 2°C/min.

After the reaction, the slurry was washed, dispersed and classified according to the process mentioned below.

### [Washing Step]

[1] 40 mL of the slurry after the reaction is subjected to solid-liquid separation at 3000 rpm for 30 minutes, using a centrifuge (Hitachi Koki's CF7D2), and the supernatant is removed.
[2] 40 mL of methanol having large polarity is added to the precipitate, which is then dispersed with an ultrasonic disperser.
[3] The above-mentioned steps [1] to [2] are repeated three times.
[4] The dispersion is processed according to the above-mentioned step [1], the supernatant is removed, and the precipitate is collected.

### [Dispersion Step]

[1] 40 mL of tetradecane having small polarity is added to the precipitate after the above-mentioned washing step.
[2] Next, this is processed with an ultrasonic disperser.

### [Classification Step]

[1] A mixture of the silver particles and 40 mL of tetradecane after the dispersion step is processed for solid-liquid separation, using the same centrifuge as above at 3000 rpm for 30 minutes.
[2] The supernatant is collected.

The supernatant is a dispersion of a silver particle powder (A). This is referred to as "dispersion (A)".

### [Production of Silver Particle Powder (B)]

23 g of oleic acid, a fatty acid, and 110 g of oleylamine, a primary amine compound, both serving as an organic protective agent, and 14 g of silver nitrate crystal, a silver compound, were added to 64 g of isobutanol, a medium also serving as a reducing agent, and stirred with a magnetic stirrer to dissolve the silver nitrate. The solution was transferred into a container equipped with a refluxing condenser, and set in an oil bath. With introducing nitrogen gas, an inert gas, at a flow rate of 400 mL/min into the container and with stirring the liquid with a magnetic stirrer at a rotational speed of 100 rpm, this was heated and kept heated under reflux at a temperature of 108°C for 6 hours. In this stage, the heating speed up to 108°C was 2°C/min.

After the reaction, the slurry was washed, dispersed and classified according to the same process as above. The supernatant obtained in [2] of the classification step is a dispersion of a silver particle powder (B). This is referred to as "dispersion (B)".

The silver particle powders (A) and (B) produced in the manner as above were analyzed through TEM according to the above-mentioned method to determine the mean particle diameter D_{TEM} thereof; and they were analyzed through differential colorimetry according to the method mentioned below to thereby determine the exothermic peaks thereof.

### [Differential Colorimetry]

25 mg of the silver particle dispersion was weighed and put on an alumina pan, and analyzed with heating from room temperature up to 900°C at a heating speed of 10°C/min. For the analysis, used was an analyzer TG-DTA2000 Model (by MacScience/Bruker AXS).

As a result, the mean particle diameter D_{TEM} of the silver particle powder (A) was 8.4 nm; and this gave an exothermic peak in differential colorimetry at 465°C. The mean particle diameter D_{TEM} of the silver particle powder (B) was 3.7 nm; and this gave an exothermic peak in differential colorimetry at 171°C, 282°C and 441°C.

Next, the dispersion (A) and the dispersion (B) produced according to the above-mentioned process were mixed in a ratio by mass, A/B of 3/2 in terms of silver, and stirred to give a dispersion containing a silver particle composite powder of this Example. The dispersion was applied onto a glass substrate according to a spin coating method to form a coating film, then left at room temperature for 5 minutes, and the glass substrate having the coating film was put on a hot plate conditioned at 200°C, and then kept as such for 60 minutes to bake the film to give a baked silver film.

Thus obtained, the baked silver film was analyzed for the adhesiveness to the substrate and the volume resistivity according to the methods mentioned below.

### [Adhesiveness Test]

Using a cutter, the baked silver film was cut to form 100 cross-cuts of 1 mm square each, and an adhesive cellophane tape having an adhesion powder of about 8 N per width of 25 mm (JIS Z1522) was stuck to it under pressure, and then peeled. The number of the remaining cross-cuts was counted. The sample in which all the 100 cross-cuts remained was the best in point of the adhesiveness thereof, and was expressed as 100/100; and the sample in which all the 100 cross-cuts peeled away was the worst in point of the adhesiveness thereof, and was expressed as 0/100. According to the adhesiveness evaluation test made in that manner, the adhesiveness of the baked silver film in this Example was expressed as 100/100 and was good.

### [Volume Resistivity]

From the surface resistance measured with a surface resistivity meter (Mitsubishi Chemical's Loresta HP), and the film thickness measured with a fluorescent X-ray film thickness meter (SII's SFT9200), the volume resistivity was determined by computation. As a result, the volume resistivity of the baked silver film of this Example was 4.5 µΩ·cm. The volume resistivity value is evaluated as low electric resistance of the silver conductive film, suitable for wiring on substrates.

### [Example 2]

An experiment was carried out under the same condition as in Example 1, using the same dispersions (A) and (B) as in Example 1 but changing the blend ratio, A/B to 1/1 by mass in terms of silver.

As a result, the adhesiveness of the baked silver film in this Example was 100/100; and the volume resistivity thereof was 4.2 µΩ·cm. Like in Example 1, good adhesiveness and low electric resistance of the film were confirmed.

### [Example 3]

An experiment was carried out under the same condition as in Example 1, using the same dispersions (A) and (B) as in Example 1 but changing the blend ratio, A/B to 2/1 by mass in terms of silver.

As a result, the adhesiveness of the baked silver film in this Example was 100/100; and the volume resistivity thereof was 4.8 µΩ·cm. Like in Example 1, good adhesiveness and low electric resistance of the film were confirmed.

### [Example 4]

An experiment was carried out under the same condition as in Example 2, for which, however, the hot plate of the baking apparatus was changed to a hot air drier, and the baking temperature was changed to 250°C.

As a result, the adhesiveness of the baked silver film in this Example was 100/100; and the volume resistivity thereof was 4.2 µΩ·cm. Like in Example 2, good adhesiveness and low electric resistance of the film were confirmed.

### [Comparative Example 1]

An experiment was carried out under the same condition as in Example 1, using the dispersion (A) alone produced in Example 1 to form the baked silver film.

As a result, the volume resistivity of the baked silver film in this Comparative Example was 2.4 µΩ·cm and was good, but the adhesiveness thereof was 0/100 and was not good.

### [Comparative Example 2]

An experiment was carried out under the same condition as in Example 1, using the dispersion (B) alone produced in Example 1 to form the baked silver film.

As a result, the adhesiveness of the baked silver film in this Comparative Example was 100/100 and was good, but the volume resistivity thereof was 6.8 µΩ·cm and was higher than that in Examples.

## Claims

1. A silver particle composite powder produced by mixing a silver particle powder (A) which bears on the surface of each silver particle, an organic protective layer comprising an amine compound having at least one unsaturated bond in one molecule and having a molecular weight of from 100 to 1000, and has a mean particle diameter D_{TEM}, as determined by TEM, of at most 50 nm and a silver particle powder (B) which bears on the surface of each silver particle, an organic protective layer comprising a fatty acid having a molecular weight of from 100 to 1000 and an amine compound having a molecular weight of from 100 to 1000 with at least any one of the fatty acid and the amine compound having at least one unsaturated bond in one molecule, and has a mean particle diameter D_{TEM} of at most 50 nm, wherein the blend ratio of the silver particle powder (A) and the silver particle powder (B) is within a range of A/B by mass of from 3/1 to 1/3 in terms of silver.

2. A silver particle composite powder as claimed in claim 1, wherein the composite powder has an exothermic peak, as determined by differential calorimetry, falling within a range of from 200 to lower than 400°C and within a range of from 400 to 600°C.

3. A dispersion of a silver particle composite powder produced by dispersing the silver particle composite powder of claim 1 or 2 in a non-polar, or poorly-polar liquid organic medium having a boiling point of from 60 to 300°C.

4. A method for producing a silver particle composite powder, comprising mixing a silver particle powder (A) which bears on the surface of each silver particle, an organic protective layer comprising an amine compound having at least one unsaturated bond in one molecule and having a molecular weight of from 100 to 1000, and has a mean particle diameter D_{TEM}, as determined by TEM, of at most 50 nm and a silver particle powder (B) which bears on the surface of each silver particle, an organic protective layer comprising a fatty acid having a molecular weight of from 100 to 1000 and an amine compound having a molecular weight of from 100 to 1000 with at least any one of the fatty acid and the amine compound having at least one unsaturated bond in one molecule, and has a mean particle diameter D_{TEM} of at most 50 nm, in a blend ratio by mass, A/B of from 3/1 to 1/3 in terms of silver.

5. The method for producing a silver particle composite powder as claimed in claim 4, wherein the silver particle powder (A) has an exothermic peak in differential calorimetry to fall within a range of from 400 to 600°C, and the silver particle powder (B) has an exothermic peak in differential calorimetry to fall within a range of from 200 to lower than 400°C and within a range of from 400 to 600°C.

6. A method for producing a baked silver film, comprising applying the dispersion of a silver particle powder of claim 3 onto a substrate to form a coating film thereon followed by baking the coating film in an oxidizing atmosphere at 300°C or lower.

## Patentansprüche

1. Silberpartikelverbundpulver, das durch Vermischen eines Silberpartikelpulvers (A), das auf der Oberfläche von jedem der Silberpartikel eine organische Schutzschicht trägt, die eine Aminverbindung aufweist, die zumindest eine ungesättigte Bindung in einem Molekül besitzt und ein Molekulargewicht von 100 bis 1000 besitzt, und das einen durchschnittlichen Partikeldurchmesser D_{TEM}, der durch ein Transmissionselektronenmikroskop bzw. TEM bestimmt wird, von höchstens 50 nm besitzt, sowie ein Silberpartikelpulver (B), das auf der Oberfläche von jedem Silberpartikel eine organische Schutzschicht trägt, die eine Fettsäure mit einem Molekulargewicht von 100 bis 1000 und eine Aminverbindung aufweist, die ein Molekulargewicht von 100 bis 1000 besitzt, wobei die Fettsäure und/oder die Aminverbindung zumindest eine ungesättigte Bindung in einem Molekül besitzen, und das einen Partikeldurchmesser D_{TEM} von maximal 50 nm besitzt, wobei das Mischverhältnis des Silberpartikelpulvers (A) und des Silberpartikelpulvers (B) innerhalb eines Bereichs von A/B der Masse von 3/1 bis 1/3 bezogen auf das Silber liegt.

2. Silberpartikelverbundpulver gemäß Anspruch 1, wobei das Verbundpulver eine exotherme Spitze besitzt, wie sie durch Differenzkalorimetrie bestimmt wird, die in einen Bereich von 200 bis unter 400°C und in einen Bereich von 400 bis 600°C fällt.

3. Dispersion eines Silberpartikelverbundpulvers, das durch Dispergieren des Silberpartikelverbundpulvers gemäß Anspruch 1 oder 2 in einem nichtpolaren oder schwach polaren, flüssigen, organischen Medium mit einem Siedepunkt von 60 bis 300°C produziert wird.

4. Verfahren zum Erzeugen eines Silberpartikelverbundpulvers, das das Vermischen eines Silberpartikelpulvers (A), das auf der Oberfläche jedes Silberpartikels eine organische Schutzschicht trägt, die eine Aminverbindung mit zumindest einer ungesättigten Säure in einem Molekül aufweist und ein Molekulargewicht von 100 bis 1000 besitzt, und das einen durchschnittlichen Partikeldurchmesser D_{TEM}, wie durch TEM bestimmt, von höchstens 50 nm besitzt, und eines Silberpartikelpulvers (B) aufweist, das auf der Oberfläche jedes Silberpartikels eine organische Schutzschicht trägt, die eine Fettsäure mit einem Molekulargewicht von 100 bis 1000, und eine Aminverbindung mit einem Molekulargewicht von 100 bis 1000 aufweist, wobei die Fettsäure und/oder die Aminverbindung zumindest eine ungesättigte Verbindung in einem Molekül besitzen, und eine durchschnittliche Partikelgröße D_{TEM} von höchstens 50 nm besitzt, und zwar in einem Mischverhältnis nach Masse von A/B von 3/1 bis 1/3 bezogen auf auf das Silber.

5. Verfahren zum Erzeugen eines Silberpartikelverbundpulvers gemäß Anspruch 4, wobei das Silberpartikelpulver (A) eine exotherme Spitze in der Differenzkalorimetrie besitzt, der in einen Bereich der von 400 bis 600°C fällt, und das Silberpartikelpulver (B) eine exotherme Spitze in der Differenzkalorimetrie besitzt, die in einen Bereich von 200 bis unter 400°C und in einen Bereich von 400 bis 600°C fällt.

6. Verfahren zum Erzeugen eines gebackenen Silberfilms, der das Auftragen einer Dispersion eines Silberpartikelpulvers gemäß Anspruch 3 auf ein Substrat, um einen Beschichtungsfilm darauf zu bilden, gefolgt von dem Backen des Beschichtungsfilms in einer Oxidationsatmosphäre bei 300°C oder weniger, umfasst.

## Revendications

1. Poudre composite de particules d'argent produite en mélangeant une poudre de particules d'argent (A) qui porte sur la surface de chaque particule d'argent, une couche de protection organique comprenant un composé amine ayant au moins une liaison insaturée dans une molécule ayant un poids moléculaire de 100 à 1000, et a un diamètre moyen de particule D_{TEM}, tel que déterminé par TEM, d'au plus 50 nm, et une poudre de particules d'argent (B) qui porte sur la surface de chaque particule d'argent, une couche de protection organique comprenant un acide gras ayant un poids moléculaire compris entre 100 et 1000 et un composé amine ayant un poids moléculaire compris entre 100 et 1000, au moins un de l'acide gras et du composé amine ayant au moins une liaison insaturée dans une molécule, et a un diamètre moyen de particule D_{TEM} d'au plus 50 nm, le rapport de mélange entre la poudre de particules d'argent (A) et la poudre de particules d'argent (B) étant dans une plage A/B en poids allant de 3/1 à 1/3 en termes d'argent.

2. Poudre composite de particules d'argent selon la revendication 1, dans laquelle la poudre composite a un pic exothermique, tel que déterminé par calorimétrie différentielle, tombant dans une plage de 200 à moins de 400°C et dans une plage de 400 à 600°C.

3. Dispersion de poudre composite de particules d'argent produite en dispersant la poudre composite de particules d'argent selon la revendication 1 ou 2 dans un milieu organique liquide non polaire ou peu polaire ayant un point d'ébullition compris entre 60 et 300°C.

4. Procédé d'obtention d'une poudre composite de particules d'argent comprenant un mélange de particules d'argent (A) qui porte sur la surface de chaque particule d'argent, une couche de protection organique comprenant un composé amine ayant au moins une liaison insaturée dans une molécule ayant un poids moléculaire de 100 à 1000, et a un diamètre moyen de particule D_{TEM}, tel que déterminé par TEM, d'au plus 50 nm, et une poudre de particules d'argent (B) qui porte sur la surface de chaque particule d'argent, une couche de protection organique comprenant un acide gras ayant un poids moléculaire compris entre 100 et 1000 et un composé amine ayant un poids moléculaire compris entre 100 et 1000, au moins un de l'acide gras et du composé amine ayant au moins une liaison insaturée dans une molécule, et a un diamètre moyen de particule D_{TEM} d'au plus 50 nm, dans un rapport de mélange A/B en poids allant de 3/1 à 1/3 en termes d'argent.

5. Procédé d'obtention d'une poudre composite de particules d'argent selon la revendication 4, dans laquelle la poudre de particules d'argent (A) a un pic exothermique, tel que déterminé par calorimétrie différentielle, tombant dans une plage de 400 à 600°C, et la poudre de particules d'argent (B) a un pic exothermique, tel que déterminé par calorimétrie différentielle, tombant dans une plage de 200 à moins de 400°C et dans une plage de 400 à 600°C.

6. Procédé d'obtention d'un film d'argent recuit comprenant l'application de la dispersion de poudre de particules d'argent selon la revendication 3 sur un substrat pour former un film de revêtement formé par recuit du film de revêtement dans une atmosphère oxydante à 300°C ou moins.
